# EUROPEAN PATENT APPLICATION

(11) **EP 1 202 616 A1**
(43) Date of publication of application: **02.05.2002**
(21) Application number: 01125579.1
(22) Date of filing: 25.10.2001
(51) Int. Cl.: H05K 9/00, H05K 1/09, C25D 5/02, C09D 5/24

(54) **EMI protective venting element for electronic housings**

(30) Priority: 28.10.2000 DE 10053681
(71) Applicant: W.L. GORE & ASSOCIATES GmbH, 85640 Putzbrunn (DE)
(72) Inventor: Protzner, Claudia, 85447 Fraunberg (DE); Schwarz, Robert, 81369 München (DE)

(57) **Abstract**

The invention relates to a plastic body with a microporous, waterproof and gas-permeable membrane for electronic housings. The plastic body has a metalized surface. Consequently, the plastic body and the housing act as a shield against the entering and leaving of electromagnetic waves. The metalized surface is preferably formed by a layer of electrically conductive material. This layer is applied to the surface of the plastic body by electroplating. At the same time, there is a high gas permeability of the membrane for venting of the electronic housing. The invention also relates to a method of producing a plastic body of this kind.

## Description

The invention concerns a waterproof plastic body having a waterproof gas-permeable membrane for electronic housings which is shielded against the entering and leaving of electromagnetic waves, with at the same time high gas permeability.

Housings, such as electronic housings, serve for accommodating electrical and electronic components and equipment, such as for example telecommunication base stations, microprocessors, microchips, personal computers, mobile phones and the like. In order to meet the high requirements of these electrical and electronic components and items of equipment with regard to electromagnetic compatibility (EMC), electronic housings must have a good shielding effect against radio-frequency electromagnetic waves in the frequency range up to 1000 GHz. On the one hand, the electronic housing must have adequate interference immunity against the continual penetration of pulse-form, line-carried and radiated electromagnetic waves. The interference immunity must be adequate for components and items of equipment to operate as intended and for no impairment in operating behavior or functional failure to occur during operation as intended. If adequate interference immunity is not provided, penetrating electromagnetic waves may cause the distortion of electrical signals or the initiation of unwanted signals. This is mainly due to the fact that electromagnetic waves are generally at a different wavelength than the operating signals of the electronic components.

On the other hand, the own electromagnetic interference emitted by the components and items of equipment must not exceed fixed limit values. These limit values are chosen such that the components and items of equipment do not produce interference at a level high enough to interfere with other equipment operating in the way intended.

This unwanted mutual influencing of electrical and electronic components by electromagnetic waves is referred to as electromagnetic interference (EMI).

It is known to produce electronic housings predominantly from metal, since metal is extremely suitable for shielding against electromagnetic waves on account of its electrical conductivity. Metal housings are nowadays generally replaced by plastic housings, since plastic housings can be produced to be lighter in weight and at lower cost. The conventional polymer materials have the disadvantage, however, that they offer no protection against electromagnetic waves, since they are non-conductors and are consequently largely permeable to electromagnetic waves. To prevent this, use is made for example of plastic housings made of a polymer material filled with electrically conductive additives, metallic linings for plastic housings and electrically conductive coatings for plastic housings.

As an electrically conductive coating, a metal layer of copper, nickel, aluminum or the like is generally provided on the surface of the plastic housings.

The miniaturization of electronic components and their housings and the increasing clock pulse frequencies of these components, such as the microprocessors in computers for example, make it increasingly more difficult to control or specifically shield against unwanted electromagnetic radiation. It is very easy for radio-frequency electromagnetic waves at a frequency between 10 MHz and 1000 GHz to enter or leave an electronic housing. It has been found that electromagnetic interference waves can enter and leave through tiny openings, gaps or slits in an otherwise shielded housing and cause interference.

Openings in an electronic housing may be, for example, openings for receiving venting elements or openings for cable bushings and so on.

Venting elements constitute an important part of an electronic housing. Influences from the surroundings of the housing and the electronic components themselves bring about temperature fluctuations in the interior of an electronic housing that cause a positive or negative pressure. For this reason, electronic housings are provided with venting elements which equalize such differences in pressure. These venting elements are usually made of plastic and may contain a waterproof and gas-permeable membrane. A venting element with a waterproof and gas-permeable membrane is sold, for example, by the company W.L. Gore & Associates GmbH, Putzbrunn, Germany, under the trade name PREVENT®.

As a consequence, components in radio-frequency technology are significantly more susceptible to radio-frequency electromagnetic waves, since they can enter and leave the housing relatively unhindered through the venting elements. Simple shielding just of the electronic housings in the way presented above is consequently no longer sufficient. This gives rise to the need to shield a housing for electronic components in radio-frequency technology as completely as possible against electromagnetic radiation.

In a first approach to this, a changeover was made to producing venting elements from metal. These have the disadvantage that the production of such an element from metal is very laborious. Furthermore, metal as a material and the process of producing a venting element from metal are very cost intensive.

The object of the present invention is to provide an electronic housing with at least one venting element which repels electromagnetic waves and has a high gas permeability for the venting of the electronic housing.

An additional object is achieved if a venting element for electronic housings which shields against electromagnetic waves is waterproof.

It is also an object of the invention to provide for a venting element for electronic housings which shields against electromagnetic waves and consists of a material which is inexpensive and easy to process.

It is an additional object of the inventionto provide for a venting element for electronic housings which shields against electromagnetic waves and can be installed in the electronic housing easily and inexpensively.

To achieve these objects, a housing with at least one plastic body containing a microporous, waterproof and gas-permeable membrane and with a metalized surface is proposed. In this case, only the plastic body has an electrically conductive coating. The membrane has no electrically conductive coating.

With such a plastic body according to the invention, an opening in the housing is shielded almost completely against the entering and leaving of electromagnetic waves. The metalized surface of the plastic body ensures the shielding of electromagnetic waves. The plastic body can be produced easily and uncomplicatedly from a polymer material and is of a low weight. As a result, the plastic body according to the invention represents an EMI-shielding venting element which can be produced easily and in a lightweight form, contains low-cost materials and allows easy fitting in the housing. The microporous, waterproof and gas-permeable membrane at the same time provides reliable protection against externally impinging water and ensures continuous and adequate gas permeability, with the result that venting can take place between the inner side and the outer side of the housing. This provides a housing which offers adequate protection against the entering and leaving of radio-frequency electromagnetic waves and consequently against EMI.

In a preferred embodiment, the plastic body has on its outer surface a layer of at least one electrically conductive material. As a result, the plastic body can be produced in a conventional way and the electrically conductive layer can be applied independently of the process for producing the plastic body. Applying the layer to the outer surface of the plastic body has the effect of shielding the entire plastic body virtually completely against electromagnetic waves. The surface of the plastic body is specifically shielded against radio-frequency electromagnetic waves, which cannot get into the interior of the electronic housing.

The degree of electromagnetic shielding is determined by the electromagnetic damping rate. The damping rate indicates how much electromagnetic radiation is emitted from the electronic housing to the surroundings, or how much electromagnetic radiation can get into the electronic housing. The plastic body according to the invention in the housing has an electromagnetic damping rate of at least 60 dB at 1 µV from a distance of 1 m. With this value, a damping rate which contributes to very good electromagnetic shielding of the entire housing is achieved.

A metal such as, for example, iron, steel, nickel, lead, copper, tin, zinc, chromium, silver and gold may be chosen as the electrically conductive material. Layers of some of these metals are corrosion-resistant and therefore suitable as an outer layer. The layer may be made up of a metal layer or a plurality of metal layers of various metals. In addition to the metals, carbon may also be used as the electrically conductive material.

For achieving adequate electromagnetic shielding, an electrically conductive layer with a minimum layer thickness is required. The minimum layer thickness ensures adequately high conductivity for the electromagnetic shielding. The layer thickness of the layer must be at least 1 µm; preferably, the layer thickness is greater than 3 µm and, in a particularly preferred embodiment, greater than 25 µm.

The layer may be applied to the outer surface of the plastic body in various ways. Suitable methods are, for example, the electroplating or electrochemical deposition of an electrically conductive layer onto the outer surface of the plastic body, dipping the plastic body into a metallic solution or brushing the outer surface of the plastic body with metal-containing coatings. Combinations of these methods are also possible. In this case, the surface of the membrane is advantageously not covered with the electrically conductive layer, in order that the gas permeability of the membrane is not influenced. The electroplating and/or electrochemical deposition process is particularly preferred. In the electroplating process, preferably at least one metal layer is applied to the outer surface of the plastic body.

With the electroplating process, it is possible to apply a closed, uniform and continuous layer to the outer surface of the plastic body. The electroplating process makes it possible for the electrically conductive metal ions to be deposited firmly and permanently on the surface on all sides. Over the duration of the electroplating process, a uniform thickness of the layer is obtained.

The plastic body is made from a polymer material which is of a low weight, can be procured at low cost and can be processed easily into the desired form. The plastic body is preferably produced by the injection-molding process. With the injection-molding process, any desired forms of the venting element can be realized in an easy way.

A thermoplastic is preferably used as the polymer material. Suitable thermoplastics may be polyamides, polyesters, ABS (acrylonitrile-butadiene-styrene) or polyoxymethylene. In a particularly preferred embodiment, the thermoplastic is a copolymer. If the plastic body is to be given an electrically conductive layer on its outer surface by an electroplating process, the polymer material must be made electroplatable. In one embodiment, the polymer material is at least one electroplatable copolymer, such as polyarylamide for example. On account of its chemical structure, polyarylamide can be electroplated particularly well.

The microporous, waterproof and gas-permeable membrane ensures that the electronic housing is protected against the ingress of water. At the same time, there is a high exchange of gas through the membrane between the interior and the exterior of the electronic housing.

Suitable materials for a microporous, waterproof and gas-permeable membrane are polyesters, polyvinyl chloride, polycarbonates, fluoropolymers, polyurethane-polyesters, polyethylene, silicones, polyolefins, polyacrylates, polyamides, polypropylene includeing polyether esters, copolyether esters and copolyether amides. Fluoropolymers such as perfluoroalkoxy (PFA), fluoroethylenepropylene (FEP) and polytetrafluoroethylene (PTFE) are preferred materials on account of their processing properties, temperature resistance and chemical resistance. Particularly preferred are porous membranes made of polytetrafluoroethylene.

Preferably, in one embodiment the membrane is highly fluorinated. In a further embodiment, the membrane is provided with a highly fluorinated coating. "Highly fluorinated" is understood in this context as meaning those polymeric materials which have a high number of fluorine atoms, which are predominantly contained in the end groups and/or lateral radicals of the molecular chain. These fluorine atoms arranged at the surface of the membrane or coating materials consequently bring about such a low surface energy of the materials that a metalization of the membrane surfaces does not take place.

Consequently, after an electroplating operation, there is no layer of an electrically conductive material on the membrane. This has the advantage that the high gas permeability of the membrane is available unchanged for the exchange of gas and the membrane continues to be waterproof and liquid proof.

Fluoropolymers, in particular fully fluorinated polymers such as PTFE, PFA, FEP and also perfluorinated and partly fluorinated polymers, may be used as the highly fluorinated membrane.

The microporous polymeric and highly fluorinated material most preferred is expanded polytetrafluoroethylene (ePTFE).

When a highly fluorinated coating is used, it may be chosen from the group of amorphous copolymers with a fraction of 10 - 40 mol % tetrafluoroethylene and 60 - 90 mol % perfluoro 2,2-dimethyl-1,3-dioxole. Copolymers of this kind are obtainable from the company Dupont under the designation Teflon® AF. For further description of this coating and its application to membranes, reference is made to the disclosure of EP-B1-561 875.

The membrane used according to the invention has a water ingress pressure of greater than 100 hPa. This makes the membrane waterproof.

The air throughput of the membrane lies around a value of < 30 Gurley seconds at a pressure of 12 hPa. Consequently, the membrane is capable of transporting gases, such as air for example, into or out of the electronic housing.

In a further advantageous development of the venting element according to the invention, the membrane is oleophobic. Such an oleophobic membrane may have in particular an oil repellency of ≥ 4, preferably an oil repellency of ≥ 8 according to the AATCC test method 118-1989 ASTM.

A method of producing a plastic body for electronic housings comprises the following steps:
a) producing a plastic body with an outer surface and with a venting duct
b) introducing a waterproof and gas-permeable membrane into the venting duct
c) applying a layer of an electrically conductive material to the outer surface of the plastic body.

The plastic body is preferably produced in an injection-molding process. The waterproof and gas-permeable membrane is adhesively bonded, thermally welded, molded or clamped into the venting duct of the plastic body. During the injection-molding process, the waterproof and gas-permeable membrane is preferably integrated into the plastic body by one of the methods presented above, for example by molding the membrane in.

The layer of an electrically conductive material is formed for example by electroplating at least one electrically conductive material onto the outer surface of the plastic body, by dipping the plastic body into a metallic solution or by brushing the outer surface of the plastic body with metallic coatings. The electroplating process is particularly preferred. Preferably, at least one metal layer is applied to the outer surface of the plastic body in an electroplating process.

A porous membrane made of expanded polytetrafluoroethylene (PTFE) is preferably used as the waterproof and gas-permeable membrane. Such a membrane is distinguished by high waterproofness and at the same time high gas permeability.

The plastic body according to the invention is now to be explained in more detail with reference to the following drawings:
Figure 1 shows a plastic body according to the invention.
Figure 2 shows a plastic body according to the invention as a component part in an electronic housing.
Figure 3 shows a section along the lines III-III in Figure 2 through the plastic body according to the invention in a housing wall of an electronic housing.
Figure 4 shows a longitudinal section through the plastic body according to the invention with an electrically conductive layer.
Figure 5 shows an enlarged partial section according to the detail V in Figure 4 of an electrically conductive layer which covers the surface of the plastic body.
Figure 6 shows the air throughputs of a conventional venting element and of the plastic body according to the invention.

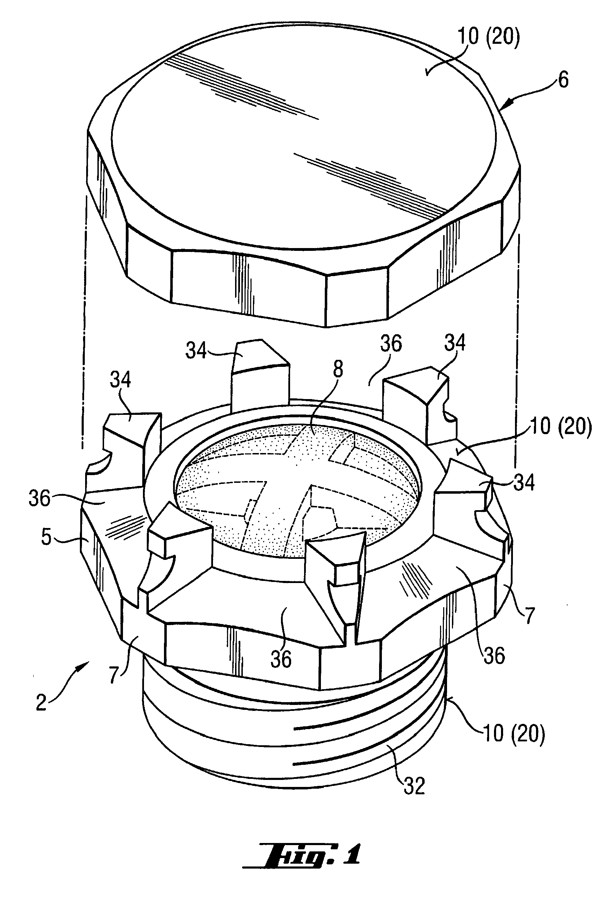

Figure 1 shows a plastic body 2 according to the invention acting as a shield against electromagnetic waves. The plastic body 2 acting as a shield against electromagnetic waves has a fastening part 9 and a support part 5, located on the fastening part 9. The support part 5 is provided with a protective cap 6. For better illustration, the protective cap 6 is shown in the state in which it is detached from the support part 5. When the element is being used, the protective cap 6 is always securely fastened on the support part 5.

In other embodiments, the plastic body 2 comprises a unitary body which has no detachable component parts.

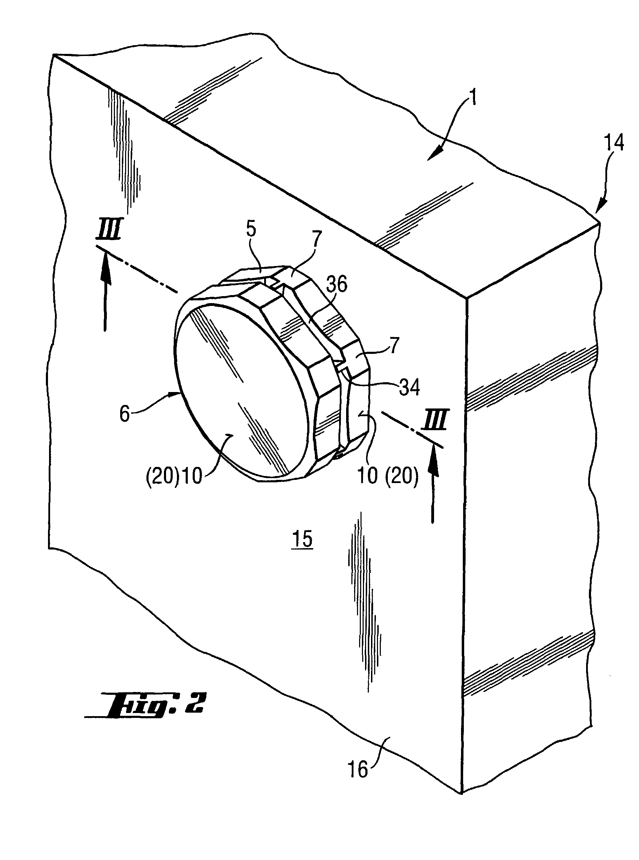

The fastening part 9 has the task of fastening the plastic body 2 in an electronic housing 1 (Figure 2). For this purpose, the fastening part 9 may be designed, for example, as a thread 32, as a snap hook or as a press fit. The fastening part 9 preferably takes the form of a thread 32.

The support part 5 may assume any desired shape, for example round or angular. The support part 5 is preferably hexagonally shaped. The hexagonal shape allows improved handling when the plastic body 2 is being fitted into the electronic housing 1. The support part 5 serves for receiving a waterproof and gas-permeable membrane 8.

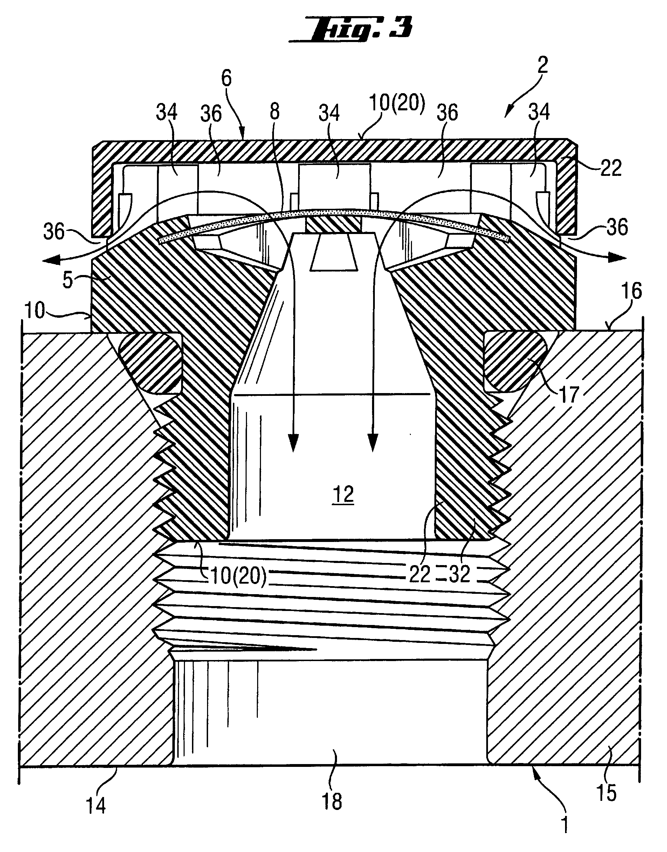

In the center of the plastic body 2 there is a venting duct 12 (Figures 3 and 4), which runs in a centered manner through the support part 5 and fastening part 9. The venting duct 12 is closed in the support part 5 by a waterproof and gas-permeable membrane 8. In the embodiment represented, the membrane 8 is protected by the protective cap 6 against mechanical damage. The membrane 8 preferably takes the form of a round shape, but it may also be of any other shape. For ensuring adequate gas exchange through the membrane 8, between the protective cap 6 and support part 5 there are spacers 34, which form the boundary of at least one intermediate space 36. The spacers 34 are preferably located on one corner 7 each of the hexagonally shaped support part 5 and surround the region of the membrane 8 in an annular form. Pairs of successive spacers 34 form the intermediate space 36. In the case of a unitary plastic body 2, a gas exchange can be realized for example by at least one bore hole in the support part 5 above the membrane 8.

The plastic body 2 is preferably formed from a polymer material, with an electrically conductive layer 10 covering the entire outer surface 20 of the polymer material. The electrically conductive layer 10 is formed from at least one electrically conductive material. In this case, the membrane 8 preferably remains uncovered by the layer 10.

Figure 2 shows the plastic body 2 according to the invention in the housing 1. The housing 1 is represented in the form of a detail and it may be of any desired shape and is preferably an electronic housing 1 which is electromagnetically shielded. Such housings 1 are used, for example, by the Bobla company, Germany, for the protection of electronic components such as amplifiers, transmitters or multiplexers for example. These housings 1 are waterproof and dustproof, preferably to the applicable IP standards (DIN 40050). The plastic body 2 according to the invention represented in Figure 2 is located in the housing wall 15 and serves as a venting element for the exchange of gas between the inner side 14 of the housing 1 and the outer side 16 of the housing 1. Of the plastic body 2 according to the invention, the protective cap 6 and the support part 5 are depicted. Between the protective cap 6 and the support part 5 there are the spacers 34, which form the boundary of intermediate spaces 36. The intermediate spaces 36 permit, in addition to further non-visible components of the plastic body 2, the venting of the housing 1.

Represented in Figure 3 is a longitudinal section through the plastic body 2, represented in Figure 2, in a housing wall 15 of an electronic housing 1 along the lines III-III in Figure 2. The plastic body 2 closes the opening 18 in the housing wall 15 which connects the inner side 14 of the housing 1 to the outer side 16 of the housing 1. The plastic body 2 includes the fastening part 9, the support part 5 and the protective cap 6 fastened thereupon. Above the fastening part 9, between the housing wall 15 and the support part 5, there is a seal 17, which ensures a waterproof fastening of the plastic body 2 in the opening 18. Through the plastic body 2 there leads a venting duct 12, through which the gas exchange between the inner side 14 and the outer side 16 of the housing 1 takes place. The venting duct 12 is closed by a waterproof and gas-permeable membrane 8 in such a way that water cannot get into the housing 1 from the outer side 16. On account of the gas permeability of the membrane 8, a gas exchange through the membrane 8 between the inner side 14 and outer side 16 of the housing 1 is ensured. For this purpose, between the support part 5 and the protective cap 6 there are the spacers 34, which are arranged on the support part 5 in such a way that between pairs of successive spacers 34 there is formed an intermediate space 36, through which a passage of gas to the outer side 16 can take place. The entire surface 20 of the plastic body 2 with the exception of the membrane 8 is covered by an electrically conductive layer 10.

Represented in Figure 4 is a further cross section of the plastic body 2 according to the invention, with further details to be given below of the shielding against electromagnetic waves. In the embodiment represented, the plastic body 2 is formed by a polymer material 22 with an outer surface 20 and by a layer 10 covering the outer surface 20. The layer 10 is made up of at least one electrically conductive material.

The polymer material 22 of the plastic body 2 comprises at least one thermoplastic. The at least one thermoplastic is chosen from the group of thermoplastics including polyamides, polyesters, polypropylene, ABS (acrylonitrile-butadiene-styrene) and polyoxymethylene. The thermoplastic is preferably a copolymer, such as polyarylamide for example. Reinforced thermoplastics such as IXEF® molding compounds are preferably used for the plastic body 2. IXEF® molding compounds are molding compounds reinforced with glass fibers and/or mineral fillers. Polyarylamide-based thermoplastics reinforced with glass fibers are preferably used. The glass fiber content serves primarily for the stabilization, dimensional stability and mechanical resistance of the plastic body 2. This polymer material is processed by the injection-molding process to form the plastic body 2. IXEF® molding compounds are available via the company Solvay Kunststoffe GmbH of Rheinberg, Germany.

The electrically conductive layer 10 covers the entire outer surface 20 of the plastic body 2. The surface 21 of the waterproof and gas-permeable membrane 8 preferably remains uncovered by the electrically conductive layer 10, with the result that the gas permeability of the membrane 8 is not restricted.

The electrically conductive material of the layer 10 is selected from the group of metals such as iron, steel, lead, nickel, copper, tin, zinc, chromium, silver and gold. Apart from their electrical conductivity, some of these metals also have a high corrosion resistance. As a further electrically conductive material, carbon may also be chosen. The layer 10 may comprise one or more layers of electrically conductive material lying one. on top of the other. In this case, various metals may be used. Metals such as nickel, chromium, tin or copper are preferably selected for the layer 10, forming the layer 10 respectively on their own or as a laminated structure.

The layer 10 is applied to the surface 20 of the plastic body 2 by electroplating, by dipping the plastic body 2 into a metal solution or by brushing the surface 20 with metallic coatings. Combinations of these method steps are also possible.

The layer 10 is preferably applied by electroplating. In the electroplating process, the metalized surface 20 of the plastic body 4, which has been made electrically conductive, is coated with a metal by electrolytic deposition. By repeating the electroplating process a number of times, a plurality of layers of various metals can be deposited on the surface 20. The duration of the electroplating process determines the thickness of the layer 10.

The electroplating of plastics is known. As part of this, the polymer surface 20 has to be given a base metalization (also know as pickling) before the actual electroplating process. The base metalization is necessary in order that the actual electroplating can take place and metal ions can attach themselves on the polymer surface 20 under current.

For the base metalization, various methods are known for making metal ions settle on the polymer surface 20 as coupling agents. Only polymer material which has on its surface an adequate number of free functional groups with which metal ions can enter into solid bonds can be electroplated. In another embodiment, during the pickling of the surface of ABS plastics with oxidizing acid mixtures, for example, the polybutadiene constituent is destroyed. As a result, pores in which the metal layer later applied by electroplating anchors itself remain in the surface.

Methods of base metalization are, for example, the sulfonation of the polymer surface with sulfonic oxide (SO₃) or methods involving dipping into heavy metal solutions. Dipping methods are, for example, the chromic acid method. Sulfonation of the polymer surface 20 is preferably used for the base metalization. Sulfonation has the advantage that, on account of the gaseous state of SO₃, plating through of the entire surface 20 of the plastic body 2 takes place. Consequently, every point on the surface 20 is treated with SO₃ gas and the surface 20 is electrically contacted completely. Sulfonation leads to the formation of functional groups which permit a chemical adsorption of palladium ions. In subsequent steps, the metals palladium (Pd) and nickel (Ni) are respectively applied by dipping methods. This concludes the base metalization of the polymer surface 20. Such a method is offered, for example, by the company Schlotter, Geilingen, Germany under the name SLOTOSIT.

Small layer thicknesses between 0.1 and 5 µm of the respective metals are adequate for the base metalization, provided that, as a result, the surface 20 is made electrically conductive for the actual electroplating.

For the actual electroplating, the base-metalized plastic body 2 is dipped into various metallic solutions. When the plastic body 2 is immersed in the metallic solutions, a galvanic current flows and metal ions are deposited on the surface 20 of the plastic body 2. Dependent on the duration of immersion, a desired layer thickness of the respective metal can be achieved.

Customary combinations of metals for electroplating plastics are nickel (Ni) - chromium (Cr), copper (Cu) - silver (Ag), nickel (Ni) - tin (Sn) or lead (Pb) - tin (Sn). With these combinations, the last-mentioned metal of a combination is always the metal electroplated last onto the surface.

The combination of metals copper, nickel - chromium or lead - tin is preferably applied. The copper layer can influence the adhesive strength of the following layers considerably.

In a further preferred embodiment, a nickel (Ni) - tin (Sn) layer 10 is electroplated onto the polymer surface 20. With this layer 10 there is the possibility of carrying out a color chromating after the electroplating, which allows the plastic body 2 to be given a colored finish.

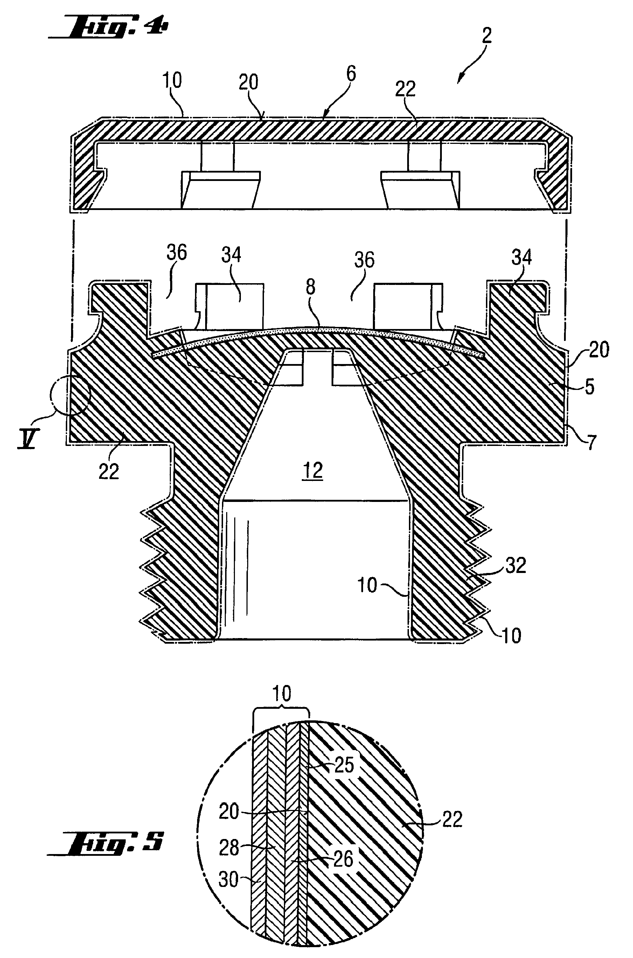

Depicted in Figure 5 is an enlarged partial cross section of the layer 10, shown as the detail V in Figure 4, of electrically conductive material, as it has been formed in the embodiment explained above. The layer 10 is made up of a plurality of metallic layers, which have been deposited on the surface 20 of the plastic body 2 by electroplating and electrochemical deposition. The base metal layer 25 applied in the base metalization contains palladium (Pd) and nickel (Ni) and has a layer thickness of 5 µm.

The metals electroplated on in an electroplating process which normally follows, copper 26, nickel 24 and chromium 30, are present with the same layer thickness each of 30 µm. Of course, other known combinations of metals may also be used.

For adequate electromagnetic shielding of the electronic housing 1, minimum layer thicknesses of the layer 10 of electrically conductive material are required. To be able to shield effectively against electromagnetic waves, a minimum layer thickness of the layer 10 of > 1 µm is required. The layer thickness is preferably > 3 µm. The layer thickness of the layer 10 is determined, for example, by X-ray fluorescence equipment for layer thickness measurement. The FISCHERSCOPE® versions of equipment from the company Helmut Fischer GmbH & Co., Germany, may be used for this purpose.

X-ray fluorescence equipment permits nondestructive and contactless measurement of the thickness and composition of all metal layers on any desired base material as well as material and solution analysis by the X-ray fluorescence method according to DIN 50 987 and ISO 3497.

Adequate layer thickness and associated high shielding against electromagnetic waves is quantitatively ascertained by the measurement of the electromagnetic damping rate. The damping rate is a value which ascertains the extent to which electromagnetic waves penetrate into the housing 1 and the extent to which electromagnetic waves pass from the housing 1 into the surroundings.

Various methods for measuring the damping rate are specified in the literature. Important test specifications for the measurement of shielding damping on a housing are formed for example by the US standards MIL-STD 461B and 285, MSA No. 65-5, MIL-G-83528B and the IEEE Std 299-1997. The VDE regulations that are important in Germany are 0871, 0872, 0875, 0877 and 0879.

The value of the damping rate is dependent on the frequency range; it is dependent on whether measurement is carried out in the electric field or in the magnetic field and whether the measurement is carried out in the near field or far field.

The effectiveness of the damping rate of items of equipment which unintentionally generate radio-frequency energy can be classified as follows:
Damping rate in (dB)
0-10 dB very low shielding
10-20 dB low shielding
20-40 dB moderate shielding
40-60 dB good shielding
60-90 dB very good shielding
over 90 dB extremely good shielding
(from "Welche Vorteile hat die chemische/elektrochemische Metallisierung von elektrischen Nichtleitern gegenüber den anderen Metallisierungsverfahren bei der elektomagnetischen Abschirmung; Mat.-wiss. und Werkstoff-tech. 23, 95-98 (1992), VCH Verlagsgesellschaft mbH, Weinheim, 1992)

A value of 10 dB means a reduction in the intensity by a factor of 10, a value of 20 dB means a reduction by a factor of 100, a value of 30 dB means a reduction by a factor of 1000 and so on.

For adequate shielding from electromagnetic waves, an electromagnetic damping rate of at least 60dB is required at 1 µV from a distance of 1 m. A damping rate of 80 dB is particularly preferred at 1µV from a distance of 1 m. The damping rate was determined by the measuring method described in the exemplary embodiment.

The waterproof, gas-permeable and microporous membrane 8 in the venting duct 12 prevents the ingress of water and dust through the plastic body 2 to the inner side 14 of the electronic housing 1. At the same time, the membrane 8 allows a high gas exchange between the inner side 14 and the outer side 16 of the housing 1.

Suitable materials for a waterproof and gas-permeable membrane are polyesters, polyvinyl chloride, polycarbonates, fluoro-polymers, polyurethane-polyesters, polyethylene, silicones, polyolefins, polyacrylates, polyamides, polypropylene including polyether esters, copolyether esters and copolyether amides.

Fluoropolymers such as perfluoroalkoxy (PFA), fluoroethylenepropylene (FEP) and polytetrafluoroethylene (PTFE) are preferred materials on account of their processing properties, temperature resistance and chemical resistance.

To avoid coating of the membrane 8 during the electroplating process, the membrane must have a very low surface energy or surface tension. "Surface energy" is understood as meaning the level of free energy per unit of surface area. The lower the surface energy of a material, the less it is able to enter into chemical interaction with other substances. Highly fluorinated materials have low surface energies. For this reason, the membrane should in fact be highly fluorinated or provided with a highly fluorinated coating. "Highly fluorinated" is understood in this context as meaning those polymeric materials which have a high number of fluorine atoms, which are predominantly contained in the end groups and/or lateral radicals of the molecular chain. These fluorine atoms are preferably present as -CF₂ or -CF₃ groups in the molecule:

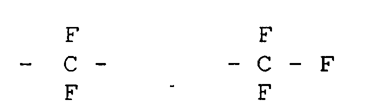

These fluorine atoms that are consequently arranged at the surface of the membrane or coating materials bring about such a low surface energy of the materials that a metalization of the membrane surface does not take place in the electroplating process.

Fluoropolymers, in particular fully fluorinated polymers such as PTFE, PFA, FEP and also partly fluorinated polymers, may be used as the highly fluorinated membrane. PTFE in particular has in comparison with other polymeric materials a very low surface energy of between 18 and 19 mN/m, depending on the method of determination (see also "Properties of Polymers", by D.W. van Krevelen, Elsevier Science B.V., 1990, Chapter 8, Tables 8.2 and 8.6).

The surface energy of solid substances such as membranes can only be determined indirectly. In addition to a series of different methods (see also "Properties of Polymers", by D.W. van Krevelen, Elsevier Science B.V., 1990, Chapter 8, page 227 et seq.), the method of determining the contact angle of different liquids on the surface of a solid substance is commonly used in practice for determining the surface energy.

The AATCC test method 118-1983 "Hydrocarbon Resistance Test" can be used for determining the surface energy of membranes. In this test, the surface of a substance is wetted with hydrocarbons (for example oils, alcohol) of different surface tension. The degree of wetting (contact angle) determines the level of the surface energy of the substance.

When a highly fluorinated coating is used, it may be chosen from the group of amorphous copolymers with a fraction of 10 - 40 mol % tetrafluoroethylene and 60 - 90 mol % perfluoro 2,2-dimethyl-1,3-dioxole. Copolymers of this kind are obtainable from the company Dupont under the designation Teflon® AF. For further description of this coating and its application to membranes, reference is made to the disclosure of EP-B1-561 875. The membane 8 should be coated in such a way that all the surfaces of the membrane have a highly fluorinated coating, the microporosity of the membrane being largely retained.

As a result of the combination of low surface energy and chemical resistance, the use of a highly fluorinated membrane or a membrane with a highly fluorinated coating has the effect that, after an electroplating operation, no film of an electrically conductive material has formed on the membrane 8. This has the advantage that the high gas permeability of the membrane is available unchanged for the exchange of gas and the membrane continues to be waterproof and liquidproof.

A microporous polymeric and highly fluorinated membrane with a microscopic structure of open interconnected microcavities is preferably used. Porous membranes made of polytetrafluoroethylene are particularly preferred. Suitable porous layers or films of polytetrafluoroethylene for this invention may be produced by known methods, such as for example by stretching or drawing methods, papermaking methods, by methods in which fillers are introduced into the PTFE resin (polymer) and subsequently removed again for creating a porous structure or by a powder-sintering process. The microporous polymeric material most preferred is expanded polytetrafluoroethylene (ePTFE). Expanded polytetrafluoroethylene is soft, flexible, has stable chemical properties, a high water vapor transfer and a surface which repels contaminants well. The patents US-A-3 953 566 and US-A-4 187 390 describe the production of such membranes from microporous expanded polytetrafluoroethylene and reference is expressly made to these patents.

Porous expanded PTFE has a structure of interconnected nodes and fibrils. These nodes and fibrils define an internal structure of a three-dimensional network of interconnected passages and paths which run vertically from surface to surface and later from boundary to boundary through the entire membrane. The porous PTFE film should have a thickness of between 3 and 1000 µm, preferably between 5 and 500µm, a pore volume of 20 to 98%, preferably from 50 to 90%, and a nominal pore size of between 0.05 and 15µm and preferably between 0.1 and 2 µm.

Porous and non-porous materials, in particular membranes, may be gas-permeable, this simply meaning the property of transporting air through the material. The membrane 8 used according to the invention is preferably microporous, because the greatest possible gas throughput can be achieved in this way. The gas throughput is dependent on the pressure differences existing, the pore size and the material thickness. Pore sizes of between 0.05 and 20 µm, preferably between 0.1 and 2 µm, are practicable. The ePTFE membrane 8 preferably used has an air throughput of ≤30 Gurley seconds. Consequently, the membrane 8 is capable of transporting gases, such as air for example, into or out of the electronic housing 1.

The air throughput may be determined, for example, with the aid of a Gurley densometer from the company W.& L.E. Gurley & Sons according to the ASTM test method D726-58. A Gurley number or Gurley seconds is/are obtained as the test result. That is the time, in seconds, which is required for 100 ccm of air to flow through a material 6.45 cm² in size at a pressure of 12hPa.

In one embodiment, the membrane 8 may be bonded on one or both sides to a backing material. The backing material may be a perforated plate or a mesh. In one embodiment, the backing material may be selected from the group of the following sintered or unsintered materials: polyester, polyamide, polypropylene, polyether, polytetrafluoro-ethylene, polysulfone, uncoated metal and coated metal. The membrane 8 preferably has no backing material.

The membrane 8 used according to the invention is waterproof, preferably at a water ingress pressure of more than 100 hPa. The term waterproof means that the material to be investigated can withstand a water ingress pressure of more than 13 hPa. The material can preferably withstand a water ingress pressure of more than 100 hPa. In a particularly preferred embodiment, the membrane 8 withstands a water ingress pressure of approximately 600 hPa. The measurement is carried out by exposing a sample of the material to be investigated with a surface area of 0.5 cm² to a rising water pressure. For this purpose, distilled water at a temperature of 20 ± 2°C is used. The water pressure rises at 60 ± 3 cm H₂O/min. The water ingress pressure of the sample corresponds to the pressure at which water passes through the opposite side of the sample. The exact method for carrying out this test is described in ISO Standard No. 811 from 1981.

In addition, the plastic body 2 is splashproof and consequently meets the requirements of IP (industrial protection) code 69K of the protective standard DIN 40050. This means that water splashing onto the plastic body 2 from any direction cannot penetrate into the housing 1.

In a further advantageous development of the plastic body 2 according to the invention, the membrane 8 is oleophobic. In particular, an oleophobic membrane 8 of this kind can have an oil repellency of ≥4, preferably an oil repellency of ≥ 8 according to the AATCC test method 118-1989 ASTM.

The membrane 8 is adhesively bonded, thermally welded, molded or clamped into, or molded onto, the venting duct 12. During the injection-molding process for producing the plastic body 2, the membrane 8 is preferably fastened in the venting duct 12. For this purpose, the membrane 8 is molded into the plastic body 2 with the aid of the insert molding method. The membrane 8 may be of any desired exterior shape; preferably, the membrane 8 is round. The membrane 8 may be fastened in the venting duct 12 such that it is straight or curved, such as for example in the form of a spherical cap. The membrane 8 is preferably molded in such that it is curved in the form of a spherical cap.

### Exemplary embodiment

For the plastic body. 2 according to the invention, the plastic body 2 having the support part 5, the threaded part 32 and the protective cap 6, as represented in Figure 4, is produced from plastic in an injection-molding process. The polymer material 22 is an IXEF molding compound of the type 1501 (highly flame retardant and with a 30% glass fiber content) from the company Solvay Kunststoffe GmbH of Rheinberg, Germany. An injection-molding machine from the company Demag, Germany, is used. The protective cap 6 is produced separately from the support part 5 and the threaded part 32. The support part 5 is hexagonal. Running through the support part 5 and the threaded part 32 is the centrally arranged cylindrical venting duct 12. During the production of the plastic body 2, the round waterproof, gas-permeable and highly fluorinated ePTFE membrane 8 is molded into the cylindrical venting duct 12 in the upper part of the support part 5. The ePTFE membrane 8 has a thickness of 300 µm. It is oleophobic with an oil repellency of eight according to the AATCC test method 118-1989 ASTM. To achieve a high level of ventilation and venting, the ePTFE membrane 8 has a Ret value of < 200 (m²Pa)/W and air throughput of ≤ 30 Gurley seconds. Furthermore, the membrane is waterproof; it withstands a water ingress pressure of greater than 600 hPa.

The hexagonal support part 5 has six spacers 34, which are arranged at a 90° angle perpendicularly with respect to the membrane 8 in one corner 7 each of the support part 5. The spacers 34 surround the region of the membrane 8 in an annular form, with at the same time mutual spacings. An intermediate space 36 lies between pairs of successive spacers 34.

The protective cap 6 is fastened onto the spacers 34, with the result that there is a gas passage through the intermediate spaces 36.

The surface 20 of the plastic body 2 produced in this way is given a metal layer 10 which is electrically conductive, and consequently acts as a shield against electromagnetic waves, by an electroplating process. As a first step, a pretreatment is carried out in the form of a sulfonation with gaseous SO₃ and a subsequent chemical application of palladium (Pd) and nickel (Ni). For the sulfonation, the plastic body 2 is suspended in a gasproof space and exposed to gaseous SO₃. The plastic body 2 is subsequently dipped successively into Pd and Ni solutions. Between these dipping processes, rinsing processes are carried out. The layer thickness of the metallic base layer thus applied is 2 µm.

Following the pretreatment, the electroplating with lead and tin ions is carried out. For this purpose, a layer of lead with a layer thickness of 15 µm and finally a layer of tin with a layer thickness of 5 µm are applied in successive electroplating steps to the surface of the plastic body 2. The total applied electrically conductive layer 10 has a layer thickness of 22 µm. During the pretreatment and during the electroplating, the surface of the membrane 8 remains unchanged, that is to say the surface of the membrane 8 is not covered by the metal layer 10.

### Test 1

For assessing the electromagnetic shielding of the metalized plastic body 2 according to the invention, the damping rate is determined by the measuring method described below, which is based on the standard IEEE Std 299-1997. An electromagnetically shielded first housing is divided by an electromagnetically shielded housing wall into a first housing chamber and a second housing chamber. The housing wall has an opening, which connects the first housing chamber to the second housing chamber. The opening has a diameter of 12 mm. The first housing is located in a second electromagnetically shielded housing, in order in this way for environmental influences to be largely excluded.

Furthermore, in the first housing chamber there is a transmitter antenna for emitting electromagnetic radiation at different frequencies (1-18 GHz). The second housing chamber has a receiver antenna, which is at a distance of 1 m from the opening. The transmitter antenna sends radiation to the housing wall and consequently to the opening. The receiver antenna measures the electromagnetic radiation passing through the housing wall from the first housing chamber.

The level of the electromagnetic radiation passing through the housing wall indicates the level of the damping rate. The less radiation is recorded in the second housing chamber, the higher the damping rate.

The damping rate is determined with the housing wall in three different forms. In a first form, the housing wall has an unclosed opening (comparison).

In a further form, the opening in the housing wall is closed with a conventional venting element, obtainable from the company W.L. Gore & Associates GmbH under the name PREVENT®. This venting element comprises a plastic body of polypropylene and has a welded-in ePTFE membrane in a venting duct. The air throughput of the venting element is <30 Gurley seconds.

In the third form, the opening in the housing wall is closed with the plastic body 2 according to the invention.

The results of the measurements are compiled in Table 1:

**Table 1**

| Comparison of electromagnetic damping rates | | | | |
|---|---|---|---|---|
| Frequency (GHz) | Comparison with free opening (dBm) | PREVENT (dBm) | Metalized plastic body (dBm) | Δ damping rate between comparison and metalized plastic body (dB) |
| 1 | -118 | -117 | -120 | 2 |
| 2.7 | -120 | -119 | -120 | 0 |
| 4.4 | -107 | -107 | -110 | 3 |
| 6.1 | -110 | -108 | -112 | 2 |
| 7.8 | -112 | -102 | -115 | 3 |
| 9.5 | -112 | -102 | -116 | 4 |
| 11.2 | -100 | -95 | -117 | 17 |
| 12.9 | -99 | -96 | -121 | 22 |
| 14.6 | -98 | -95 | -123 | 25 |
| 16.3 | -94 | -93 | -125 | 31 |
| 18 | -103 | -101 | -132 | 29 |

A housing which has no electromagnetic shielding has a damping rate of 0, since almost all the transmitted electromagnetic radiation is received outside the housing. On the other hand, a completely electromagnetically shielded housing has a damping rate of which the value tends toward infinity.

The evaluation of the damping rates for the comparative measurements shows that the otherwise completely shielded first housing chamber with the opening in the housing wall has received an interruption in the shielding. The comparison of damping rate and wavelength of the electromagnetic radiation makes it clear that, at the longer frequencies of 1-9.5 GHz, most of the waves cannot pass through the opening since it is too small. With an increase in frequency (> 9.5 GHz), and consequently a reduction in the wavelength, the damping rate also clearly decreases, i.e. an increased electromagnetic radiation was measured outside the first housing chamber.

The closing of the opening with a PREVENT® venting element shows no significant change in the decrease in the damping rate at higher frequencies.

The closing of the opening with the plastic body according to the invention shows a clear improvement in the electromagnetic shielding, in particular from a frequency of ≈10 GHz. At a frequency of 16.3 GHz, a damping rate of 125 dB is obtained with the plastic body according to the invention, corresponding to an improvement in comparison with the unclosed opening of 31 dB. These values show that the plastic body according to the invention ensures excellent electromagnetic shielding of the opening, in particular when there is an increase in the frequencies.

### Test 2

The air throughput of the metalized plastic body 2 was determined by the method described above in comparison with the PREVENT® venting element described above.

The plastic body 2 was produced by the method described in Test 1. After priming with palladium (Pa) and tin (Sn), the plastic body 2 received a copper-nickel coating as the metallic coating. The determination of the air throughput is carried out by the method described above. Table 2 shows the measurement results in Gurley seconds:

**Table 2**

| PREVENT® | plastic body according to the invention |
|---|---|
| 21.4 | 19.0 |
| 22.1 | 22.0 |
| 20.0 | 21.7 |
| 22.3 | 23.0 |
| 23.5 | 23.1 |
| 20.0 | 22.5 |
| 21.9 | 20.5 |
| 27.4 | 22.8 |
| 17.7 | 19.6 |
| 24.0 | 21.3 |
| **mean:22.0** | **mean:21.6** |

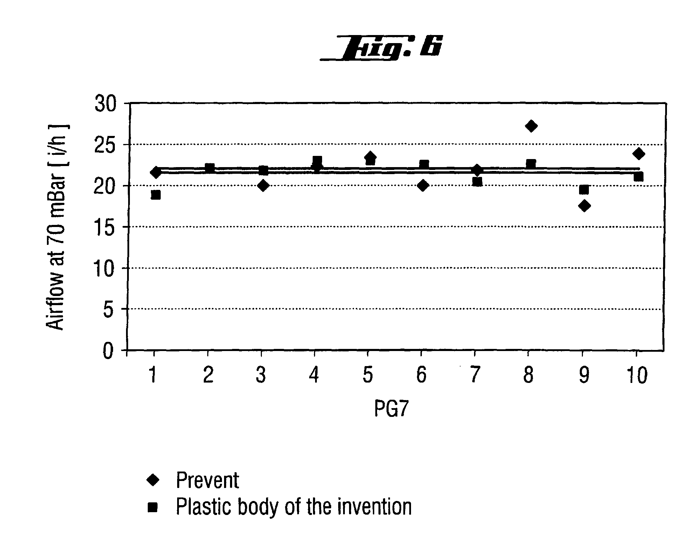

In Figure 6, the comparison between the air throughputs is graphically represented. It can be seen both from Table 2 and Figure 6 that the air throughput of the plastic body according to the invention does not differ significantly from the air throughput of the conventional PREVENT® venting element. Consequently, the membrane in the plastic body has retained its high air permeability after the electroplating.

## Claims

1. A housing with at least one plastic body containing a microporous, waterproof and gas-permeable membrane, wherein the plastic body has a metalized surface.

2. The housing as claimed in claim 1, wherein the membrane is highly fluorinated.

3. The housing as claimed in claim 1, wherein the membrane has a highly fluorinated coating.

4. The housing as claimed in claim 1, wherein the plastic body has an electromagnetic damping rate of at least 60 dB at 1 µV from a distance of 1 m.

5. The housing as claimed in claim 1, wherein the metalized surface contains a layer of at least one electrically conductive material.

6. The housing as claimed in claim 5, wherein the layer is applied to the surface of the plastic body by means of electroplating.

7. The housing as claimed in claim 5, wherein the layer has a layer thickness of ≥ 1 µm.

8. The housing as claimed in claim 5, wherein the layer has a layer thickness of > 25 µm.

9. The housing as claimed in claim 1, wherein the plastic body contains at least one thermoplastic.

10. The housing as claimed in claim 9, wherein the thermoplastic is selected from the group of thermoplastics including polyamides, polyesters, polyoxymethylene and ABS (acrylonitrile-butadiene-styrene).

11. The housing as claimed in claim 9, wherein the thermoplastic is a copolymer.

12. The housing as claimed in claim 1, wherein the plastic body contains at least one electroplatable copolymer.

13. The housing as claimed in claim 12, wherein the at least one electroplatable copolymer is a polyarylamide.

14. The housing as claimed in claim 5, wherein the electrically conductive material is selected from the group of metals such as iron, steel, nickel, copper, tin, chromium, silver and gold.

15. The housing as claimed in claim 5, wherein the electrically conductive material is carbon.

16. The housing as claimed in claim 1, wherein the plastic body is injection molded.

17. The housing as claimed in claim 1, wherein the membrane is selected from a material from the group of substances comprising polyesters, polyamides, polyolefins including polyethylene and polypropylene, polyvinyl chloride, polycarbonates, fluoropolymers, polytetrafluoroethylene (PTFE), polyacrylates, copolyether esters and copolyether amides.

18. The housing as claimed in claim 1, wherein the membrane consists of expanded PTFE.

19. The housing as claimed in claim 1, wherein the membrane has a water entry pressure of greater than 100 hPa.

20. The housing as claimed in claim 1, wherein the membrane has an air throughput of < 30 Gurley seconds at a pressure of 12 hPa.

21. A housing with at least one venting element; the electronic housing having an inner side and an outer side and at least one opening for connecting the inner side to the outer side and the venting element being arranged in the at least one opening, wherein the venting element has a body acting as a shield against electromagnetic waves with a venting duct, the body being made up of least one polymer material, having an outer surface and a layer covering the outer surface, and the layer is made of at least one electrically conductive material, and a waterproof and gas-permeable membrane is arranged in the venting duct.

22. A plastic body for housings; the plastic body containing a microporous, waterproof and gas-permeable membrane, the plastic body having a metalized surface.

23. The plastic body as claimed in claim 22, wherein the membrane is highly fluorinated.

24. The plastic body as claimed in claim 22, wherein the membrane has a highly fluorinated coating.

25. The plastic body as claimed in claim 22, wherein the plastic body has an electromagnetic damping rate of at least 60 dB at 1 µV from a distance of 1 m.

26. The plastic body as claimed in claim 22, the metalized surface containing a layer of at least one electrically conductive material.

27. The plastic body as claimed in claim 26, wherein the layer is applied to the surface of the plastic body by means of electroplating.

28. The plastic body as claimed in claim 26, wherein the layer has a layer thickness of ≥1µm.

29. The plastic body as claimed in claim 26, wherein the layer has a layer thickness of >25µm.

30. The plastic body as claimed in claim 22, wherein the plastic body containing at least one thermoplastic.

31. The plastic body as claimed in claim 30, wherein the thermoplastic is selected from the group of thermoplastics including polyamides, polyesters, polyoxymethylene and ABS (acrylonitrile-butadiene-styrene).

32. The plastic body as claimed in claim 30, wherein the thermoplastic is a copolymer.

33. The plastic body as claimed in claim 22, wherein the plastic body has at least one electroplatable copolymer.

34. The plastic body as claimed in claim 33, wherein the at least one electroplatable copolymer is a polyarylamide.

35. The plastic body as claimed in claim 26, wherein the electrically conductive material is selected from the group of metals such as iron, steel, nickel, copper, tin, chromium, silver and gold.

36. The plastic body as claimed in claim 26, wherein the electrically conductive material is carbon.

37. The plastic body as claimed in claim 22, wherein the plastic body is injection molded.

38. The plastic body as claimed in claim 22, wherein the membrane consists of a material from the group of substances comprising polyesters, polyamides, polyolefins including polyethylene and polypropylene, polyvinyl chloride, polycarbonates, fluoropolymers, polytetrafluoroethylene (PTFE), polyacrylates, copolyether esters and copolyether amides.

39. The plastic body as claimed in claim 22, wherein the membrane consists of expanded PTFE.

40. The plastic body as claimed in claim 22, wherein the membrane has a water ingress pressure of greater than 100 hPa.

41. The plastic body as claimed in claim 22, wherein the membrane has an air throughput of < 30 Gurley seconds at a pressure of 12 hPa.

42. A venting element for electronic housings; the venting element having a body which acts as a shield against electromagnetic waves with an outer surface, the body having a venting duct and being made at least partly from a polymer material, wherein a waterproof and gas-permeable membrane is arranged within the venting duct and the body has a layer covering the surface, and the layer is made up of at least one electrically conductive material, so that the venting element is electromagnetically shielded.

43. A method of producing a plastic body for housings, with the following steps:
a) producing a plastic body with an outer surface and with a venting duct
b) introducing a waterproof and gas-permeable membrane into the venting duct
c) applying a layer of at least one electrically conductive material to the outer surface of the plastic body [sic].

44. The method as claimed in claim 43, wherein the layer is applied in step c) by electroplating, dipping into a metal solution or brushing the outer surface.

45. The method as claimed in claim 43, wherein the layer is applied in step c) by electroplating.

46. The method as claimed in claim 43, wherein the electrically conductive material is selected from the group of metals such as iron, steel, nickel, copper, tin, chromium, silver and gold.

47. The method as claimed in claim 43, wherein the electrically conductive material is carbon.

48. The method as claimed in claim 43, wherein steps a) and b) are performed simultaneously.

49. The method as claimed in claim 43, wherein the membrane (8) is adhesively bonded, thermally welded, molded or clamped into the venting duct.

50. The method as claimed in claim 43, wherein the plastic body [sic] is produced in an injection-molding process.

51. The method as claimed in claim 43, wherein the membrane consists of a material from the group of substances comprising polyesters, polyamides, polyolefins including polyethylene and polypropylene, polyvinyl chloride, polycarbonates, fluoropolymers, polytetrafluoroethylene (PTFE), polyacrylates, copolyether esters and copolyether amides.

52. The method as claimed in claim 43, wherein the membrane is expanded PTFE.

53. The method as claimed in claim 43, wherein the membrane is highly fluorinated.

54. The method as claimed in claim 43, wherein the membrane has a highly fluorinated coating.
